# EUROPEAN PATENT APPLICATION

(11) **EP 4 819 486 A1**
(43) Date of publication of application: **07.10.2026**
(21) Application number: 24918919.2
(22) Date of filing: 28.06.2024
(51) Int. Cl.: H02S 50/00, H02S 40/32, G06N 3/09, G06T 7/70, G06T 7/60, G01C 9/02, G01C 19/02, G06T 11/00, G06F 3/0486

(54) **METHOD AND APPARATUS FOR AUTOMATICALLY MAPPING INVERTER OF PHOTOVOLTAIC MODULE**

(30) Priority: 17.01.2024 KR 20240007333; 28.02.2024 KR 20240028770
(71) Applicant: Hanwha Solutions Corporation, Jung-gu Seoul 04541 (KR)
(72) Inventor: KIM, Sang Min, Seoul 04541 (KR); BONG, Sung Chan, Seoul 04541 (KR); BAEK, Eun Je, Seoul 04541 (KR)
(74) Representative: Mooser, Sebastian Thomas
(86) International application number: PCT/KR2024/009073
(87) International publication number: WO 2025/154885

(57) **Abstract**

Provided is a method of automatically mapping inverters in photovoltaic modules, the method including receiving a list of pieces of identification information about micro-inverters respectively corresponding to a plurality of photovoltaic modules that are installed, receiving a first image including a plurality of first codes from a user, obtaining position information and identification information of the micro-inverter corresponding to the first code by recognizing the first codes, generating a first layout diagram of the micro-inverters based on the obtained position information and identification information, comparing the number of the pieces of identification information of the micro-inverters in the list of pieces of identification information with the number of pieces of identification information corresponding to the recognized plurality of first codes, and sending an alarm and recommending position information of a micro-inverter corresponding to an unrecognized first code on the first layout diagram, when the numbers do not match each other, and modifying the first layout diagram based on the recommended position information.

## Description

### Technical Field

The present disclosure relates to a method and apparatus for automatically mapping inverters in photovoltaic modules.

### Background Art

Recently, with the growing interest in eco-friendly energy technologies, there has been an increase in the deployment of solar power generation systems that utilize sunlight to generate energy. A solar power generation system is a system that collects solar energy through photovoltaic (PV) modules to produce electricity, and the electricity generated is supplied to the home's power grid for household use or stored in batteries for later use. Generating electricity through solar power generation systems is environmentally friendly and leads to long-term savings on electricity bills, making it increasingly popular.

Typically, a solar power generation system includes a plurality of photovoltaic (PV) modules installed therein, each equipped with a micro-inverter that serves to convert the generated energy. After installing the plurality of photovoltaic modules, an installer must perform a process of mapping the photovoltaic modules onto a layout. At this point, the installer encounters the inconvenience of manually scanning codes that include identification information for each photovoltaic module or micro-inverter, and then matching this identification information with the corresponding position information, and thus, various methods are being researched to streamline this process.

The background technology described above is technical information that the inventor(s) of the present disclosure has achieved to derive the present disclosure or has achieved during the derivation of the present disclosure, and thus, it cannot be considered that the background technology has been published to the public before the filing of the present disclosure.

### Detailed Description of the Invention

### Technical Problem

The present disclosure is directed to providing a method of simultaneously recognizing and managing identification information of a plurality of photovoltaic modules or micro-inverters.

The present disclosure is also directed to providing a layout diagram for a plurality of photovoltaic modules, which facilitates the easy collection and management of position information of the photovoltaic modules.

The present disclosure is also directed to calculating installation information, including tilt and azimuth angles, from an image including an installed state of a plurality of photovoltaic modules in order to modify a layout diagram, thereby generating more accurate mapping results that actually reflect site conditions.

The problems to be solved by the present disclosure are not limited to the above-mentioned problems, and other problems and advantages of the present disclosure, which are not mentioned, can be understood by the following description, and will be more clearly understood from the embodiments of the present disclosure. It will also be appreciated that the problem and advantages to be solved by the present disclosure may be implemented by the means and combinations thereof indicated in the claims.

### Technical Solution

According to an aspect of the present disclosure, there is provided a method of automatically mapping inverters in photovoltaic modules, the method including receiving a list of pieces of identification information about micro-inverters respectively corresponding to a plurality of photovoltaic modules that are installed, receiving a first image including a plurality of first codes from a user, obtaining position information and identification information of the micro-inverter corresponding to the first code by recognizing the first codes, generating a first layout diagram of the micro-inverters based on the obtained position information and identification information, comparing the number of the pieces of identification information of the micro-inverters in the list of pieces of identification information with the number of pieces of identification information corresponding to the recognized plurality of first codes, and sending an alarm and recommending position information of a micro-inverter corresponding to an unrecognized first code on the first layout diagram, when the numbers do not match each other, and modifying the first layout diagram based on the recommended position information.

In the present disclosure, the method may further include receiving a second image showing an installed state of the plurality of photovoltaic modules from the user,
calculating installation information related to the plurality of photovoltaic modules from the second image, and generating a second layout diagram by modifying the first layout diagram based on the installation information.

In the present disclosure, the obtaining of the position information and the identification information of the micro-inverter may include recognizing the first code included in the first image, identifying coordinate information of a zone to which the first code is attached, and obtaining the position information of the micro-inverter using the coordinate information.

In the present disclosure, the obtaining of the position information and the identification information of the micro-inverter may include, when the coordinate information of the zone to which the first code is attached is identified as a plurality of pieces of coordinate information, obtaining the position information of the micro-inverter using the coordinate information of the zone having a largest area of the first code.

In the present disclosure, the generating of the first layout diagram may include obtaining cardinal direction information from the first image, changing the position information of the micro-inverter based on the cardinal direction information, and generating the first layout diagram based on the changed position information and the identification information.

In the present disclosure, the generating of the first layout diagram may include reflecting position information of the micro-inverter changed by a user's drag and drop input, and generating the first layout diagram based on the reflected position information and the identification information.

In the present disclosure, the first code is replaceable with a second code corresponding to the identification information of the photovoltaic module.

In the present disclosure, the method may further include obtaining pieces of identification information of the photovoltaic modules, which respectively correspond to pieces of identification information of a plurality of micro-inverters, from a database, and corresponding the first code to one of a plurality of second codes, based on the database.

According to another aspect of the present disclosure, there is provided a method of automatically mapping inverters in photovoltaic modules, the method including receiving a list of pieces of identification information about micro-inverters respectively corresponding to a plurality of photovoltaic modules that are installed, receiving a first image including a plurality of first codes from a user, obtaining position information and identification information of the micro-inverter corresponding to the first code by recognizing the first codes included in the first image, generating a first layout diagram of the micro-inverters based on the obtained position information and identification information of the micro-inverter, receiving a second image showing an installed state of the plurality of photovoltaic modules from the user, calculating installation information related to the plurality of photovoltaic modules from the second image, and generating a second layout diagram by modifying the first layout diagram of the micro-inverters based on the installation information.

In the present disclosure, the obtaining of the position information and the identification information may include recognizing the first code included in the first image, identifying coordinate information of a zone to which the first code is attached, and obtaining the position information of the micro-inverter.

In the present disclosure, the obtaining of the position information and the identification information of the micro-inverter may include, when the coordinate information of the zone to which the first code is attached is identified as a plurality of pieces of coordinate information, obtaining the position information of the micro-inverter using the coordinate information of the zone having a largest area of the first code.

In the present disclosure, the generating of the installation information may include receiving a tilt angle and an azimuth angle, which are measured corresponding to the second image by an acceleration sensor and a gyroscope sensor provided in the user terminal, and determining the tilt angle and the azimuth angle as the installation information related to the plurality of photovoltaic modules.

In the present disclosure, the generating of the installation information may include extracting a roof, on which the plurality of photovoltaic modules are installed, and a ground from the second image, and calculating the tilt angle as an inclination of the roof with respect to the ground, calculating the azimuth angle of the plurality of photovoltaic modules based on information included in metadata of the second image and the tilt angle, and determining the tilt angle and the azimuth angle as the installation information related to the plurality of photovoltaic modules.

In the present disclosure, the generating of the installation information may include generating the installation information related to the plurality of photovoltaic modules corresponding to the second image, using a deep neural network model pre-trained to generate installation information related to a plurality of photovoltaic modules in response to an image showing an installed state of the plurality of photovoltaic modules, wherein the deep neural network model may be a model trained using a supervised learning method, with the image showing the installed state of the plurality of photovoltaic modules as input, and tilt and azimuth angles of a photovoltaic module as labels.

In the present disclosure, the generating of the installation information may include loading a solar power installation drawing generated when installing the plurality of photovoltaic modules, extracting a tilt angle and an azimuth angle included in the solar power installation drawing, and determining the tilt angle and azimuth angle as the installation information related to the plurality of photovoltaic modules.

In the present disclosure, the generating of the second layout diagram may include generating a modification result of the first layout diagram, which is obtained by modifying the first layout diagram based on the tilt angle and the azimuth angle included in the installation information, and determining the modification result of the first layout diagram as the second layout diagram.

According to another aspect of the present disclosure, there is provided an apparatus for automatically mapping inverters in photovoltaic modules, the apparatus including at least one processor, and at least one memory, wherein the at least one processor is configured to receive a list of pieces of identification information about micro-inverters respectively corresponding to a plurality of photovoltaic modules that are installed, receive a photograph including a plurality of first codes from a user, obtain position information and identification information of the micro-inverter corresponding to the first code by recognizing the first codes, output a layout diagram of the micro-inverters to a user terminal based on the obtained position information and identification information, compare the number of the pieces of identification information of the micro-inverters in the list of pieces of identification information with the number of pieces of identification information corresponding to the recognized plurality of first codes, and send an alarm and recommend position information of a micro-inverter corresponding to an unrecognized first code on the first layout diagram, when the numbers do not match each other, and modify the first layout diagram based on the recommended position information.

According to another aspect of the present disclosure, there is provided an apparatus for automatically mapping inverters in photovoltaic modules, the apparatus including at least one processor, and at least one memory, wherein the at least one processor may be configured to receive a list of pieces of identification information about micro-inverters respectively corresponding to a plurality of photovoltaic modules that are installed, receive a first image including a plurality of first codes from a user, obtain position information and identification information of the micro-inverter corresponding to the first code by recognizing the first codes, generate a first layout diagram of the micro-inverters based on the obtained position information and identification information of the micro-inverter, receive a second image showing an installed state of the plurality of photovoltaic modules from the user, generate installation information related to the plurality of photovoltaic modules from the second image, and generate a second layout diagram by modifying the first layout diagram of the micro-inverters based on the installation information.

According to another aspect of the present disclosure, there is provided a computer-readable recording medium recording a program for executing the above-described method on a computer.

Other aspects, features, and advantages other than those described above will become apparent from the following drawings, claims, and detailed description of the disclosure.

### Advantageous Effects

According to the present disclosure, a plurality of pieces of identification information of a plurality of micro-inverters can be easily managed by simultaneously recognizing the plurality of pieces of identification information.

Further, by generating a layout diagram based on pieces of position information of photovoltaic modules respectively corresponding to the plurality of micro-inverters, the pieces of position information of the photovoltaic modules each including the micro-inverter can be easily collected and managed.

Further, by calculating tilt and azimuth angles from an image showing an installed state of a plurality of photovoltaic modules and adding the tilt and azimuth angles to the layout diagram, more accurate mapping results can be obtained that actually reflect the state of a site.

Further, by outputting the layout diagram including the identification information and position information of the plurality of photovoltaic modules or micro-inverters, and installation information including information about the tilt and azimuth angles to a user terminal, a user can easily check and modify the position information.

Further, when the identification information of the micro-inverter is lost or cannot be recognized, the identification information can be replaced by recognizing the identification information of the photovoltaic module, thereby improving convenience of use.

Effects of the present disclosure are not limited to those mentioned above, and other effects that are not mentioned will be clearly understood by those skilled in the art from the description below.

### Brief Description of Drawings

FIG. 1 is an exemplary diagram for describing an example of an apparatus for automatically mapping inverters in photovoltaic modules;
FIG. 2 is a flowchart illustrating a method of automatically mapping the inverters in the photovoltaic modules according to an embodiment;
FIG. 3 is an exemplary diagram of a first image including a plurality of first codes according to an embodiment;
FIG. 4 is an exemplary diagram illustrating a process of recognizing the first image and outputting a first layout diagram, according to an embodiment;
FIG. 5 is an exemplary diagram of a first image in which an unattached first code is present, according to an embodiment;
FIG. 6 is an exemplary diagram illustrating a process of recognizing the first image and outputting a first layout diagram, according to another embodiment;
FIG. 7 is an exemplary diagram of a first image including a first code attached to a boundary, according to an embodiment;
FIG. 8 is an exemplary diagram illustrating a process of recognizing the first image and outputting a first layout diagram, according to another embodiment;
FIG. 9 is an exemplary diagram of a second image showing an installed state of a plurality of photovoltaic modules, according to an embodiment;
FIGS. 10A and 10B are exemplary diagrams illustrating the calculation of installation information from the second image, according to an embodiment;
FIG. 11 is an exemplary diagram illustrating a process of outputting a second layout diagram based on the installation information, according to an embodiment.

### Best Mode

According to an aspect of the present disclosure, there is provided a method of automatically mapping inverters in photovoltaic modules, the method including receiving a list of pieces of identification information about micro-inverters respectively corresponding to a plurality of photovoltaic modules that are installed, receiving a first image including a plurality of first codes from a user, obtaining position information and identification information of the micro-inverter corresponding to the first code by recognizing the first codes, generating a first layout diagram of the micro-inverters based on the obtained position information and identification information, comparing the number of the pieces of identification information of the micro-inverters in the list of pieces of identification information with the number of pieces of identification information corresponding to the recognized plurality of first codes, and sending an alarm and recommending position information of a micro-inverter corresponding to an unrecognized first code on the first layout diagram, when the numbers do not match each other, and modifying the first layout diagram based on the recommended position information.

### Mode of Disclosure

The advantages and features of the present disclosure and methods of achieving them will be apparent from the embodiments that will be described in detail with reference to the accompanying drawings. However, the present disclosure is not limited to the following embodiments, but may be implemented in various forms different from each other, and is to be understood to include all modifications, equivalents, or substitutions that may be implemented in a variety of different forms and that are within the scope of the ideas and techniques of the present disclosure. The embodiments presented below are only provided to make the disclosure of the present disclosure complete and fully inform those skilled in the technical field to which the present disclosure pertains of the scope of the present disclosure. In describing the present disclosure, a detailed description of known related arts will be omitted when it is determined that the gist of the present disclosure may be unnecessarily obscured

The terms used herein are for the purpose of describing particular embodiments only and are not intended to be limiting to the present disclosure. Singular forms are intended to include plural forms as well, unless the context clearly indicates otherwise. In the present application, it will be further understood that the terms "comprise," "comprising," "include," and/or "including," when used in this specification, specify the presence of stated features, integers, steps, operations, elements, components and/or groups thereof but do not preclude the presence or addition of one or more other features, integers, steps, operations, elements, components and/or groups thereof. Although terms such as "first", "second", and the like may be used to describe various components, such components should not be limited to the above terms. These terms are used only for the purpose of distinguishing one component from another component.

In addition, in the present application, a "part" may be a hardware component such as a processor or a circuit, and/or a software component executed by a hardware component such as a processor.

Hereinafter, the embodiments according to the present disclosure will be described below in detail with reference to the accompanying drawings, and when the embodiments of the present disclosure are described with reference to the drawings, the same or corresponding components are given the same reference numerals, and repetitive descriptions thereof will be omitted.

In the following embodiments, the terms "first", "second", and the like have been used to distinguish one component from another, rather than limitative in all aspects.

In the following embodiments, singular forms are intended to include plural forms as well, unless the context clearly indicates otherwise.

In the following embodiments, the terms such as "including," "having," and "comprising" are intended to indicate the existence of features or components disclosed in the specification, and are not intended to preclude the possibility that one or more other features or components may be added.

When a certain embodiment may be implemented differently, a specific process order may be performed differently from the described order. For example, two consecutively described processes may be performed substantially at the same time or performed in an order opposite to the described order.

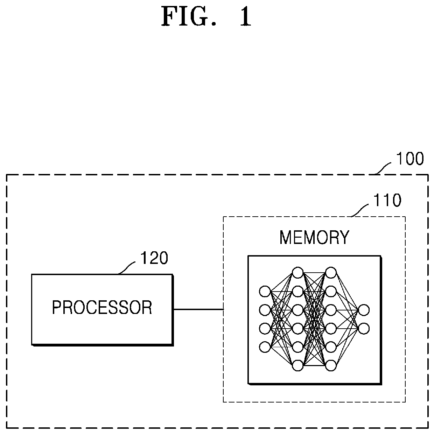

FIG. 1 is an exemplary diagram for describing an example of an apparatus for automatically mapping inverters in photovoltaic modules.

Referring to FIG. 1, an apparatus 100 for automatically mapping inverters in photovoltaic modules (hereinafter referred to as an "apparatus 100") may include a memory 110 and a processor 120.

The apparatus 100 shown in FIG. 1 illustrates only components related to the present embodiments, and it will be apparent to those skilled in the art that other general-purpose elements may be included in addition to the components illustrated in FIG. 1.

For example, the apparatus 100 may be implemented as various types of devices, including a notebook personal computer (PC), a desktop PC, a laptop, a tablet computer, a mobile device including a smartphone, a server device, an embedded device, and the like. As a specific example, the apparatus 100 may correspond to a smartphone, s tablet device, an augmented reality (AR) device, an Internet-of-Things (IoT) device, an autonomous vehicle, or the like capable of performing voice recognition, image recognition, image classification, and the like using artificial intelligence, but the present disclosure is not limited thereto. Furthermore, the apparatus 100 may include a dedicated hardware accelerator (HW accelerator) installed in the above-described device, or may include a hardware accelerator such as a neural processing unit (NPU), a tensor processing unit (TPU), or a neural engine that is a dedicated module for driving artificial intelligence.

The memory 110 is hardware that stores various pieces of data processed in the apparatus 100, and may include a computer-readable describing medium. For example, the memory 110 may store pieces of data processed and to be processed in the apparatus 100. In addition, the memory 110 may store applications, drivers, and the like to be driven by the apparatus 100. The memory 110 may include at least one of a volatile memory or a nonvolatile memory. The volatile memory may include a dynamic random access memory (DRAM), a static random access memory (SRAM), a synchronous dynamic random access memory (SDRAM), a phase-change random access memory (PRAM), a magnetic random access memory (MRAM), resistive random access memory (RRAM), a ferroelectric random access memory (FeRAM), and the like. The non-volatile memory may include a read-only memory (ROM), a programmable read-only memory (PROM), an electrically programmable read-only memory (EPROM), an electrically erasable programmable read-only memory (EEPROM), and the like.

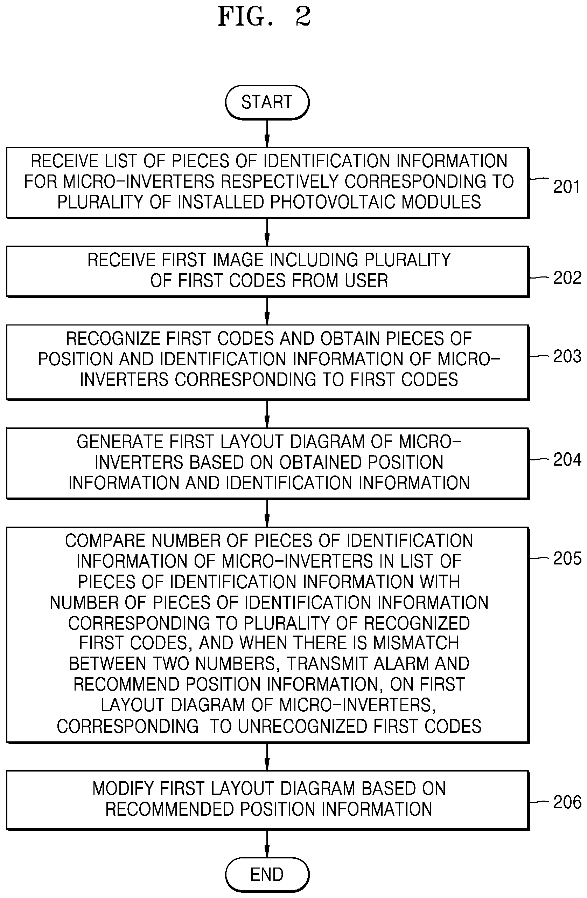

In the embodiment, the memory 110 may include magnetic memory, a CD-ROM, a Blu-ray or other optical disk storage, a hard disk drive (HDD), a solid state drive (SSD), a compact flash (CF), a secure digital (SD), a micro secure digital (Micro-SD), a mini secure digital (Mini-SD), an extreme digital (xD), or a memory stick, but the present disclosure is not limited thereto. In addition, the memory 110 may store an operating system and at least one program code (the code to be executed by the processor 120 for operations to be illustrated with reference to FIGS. 2 to 11).

The processor 120 may serve to control overall functions necessary for operating the apparatus 100, as will be described with reference to FIGS. 2 to 11. For example, by executing software (e.g., a program) stored in the memory 110 within the apparatus 100, the processor 110 may control at least one or more other components (e.g., hardware or software components) of an electronic device connected to the processor 120 and control the overall operation of apparatus 100 through various data processing and computational tasks.

For example, the processor 120 may receive a list of pieces of identification information for micro-inverters respectively corresponding to a plurality of installed photovoltaic modules. In addition, the processor 120 may receive a first image including a plurality of first codes from a user. At this point, the processor 120 may recognize the first codes included in the first image, identify pieces of coordinate information of zones to which the first codes are attached, and obtain pieces of position information about positions of the micro-inverters using the coordinate information. In addition, since a plurality of pieces of coordinate information of the zones to which the first codes are attached are recognized, the processor 120 may obtain the position information of the micro-inverter using the coordinate information of the zone having the largest area of the first code.

Meanwhile, the processor 120 may generate a first layout diagram for the micro-inverters based on the obtained position information and the identification information. At this point, the processor 120 may obtain cardinal direction information from the first image, change the position information of the micro-inverter based on the cardinal direction information, and generate the first layout diagram based on the changed position information and the identification information. In addition, the processor 120 may reflect position information of the micro-inverter, which is changed by a user's drag and drop input, and may generate the first layout diagram based on the reflected position information and the identification information.

Meanwhile, the processor 120 may compare the number of the pieces of identification information for the micro-inverters in the list of pieces of identification information with the number corresponding to the plurality of recognized first codes, and when there is a mismatch therebetween, the processor 120 may transmit an alarm and recommend position information on the first layout diagram of micro-inverters corresponding to unrecognized first codes. In addition, the processor 120 may modify the first layout diagram based on the recommended position information.

Meanwhile, the first code may be replaced with a second code corresponding to the identification information of the photovoltaic module, and the processor 120 may build a database such that the pieces of identification information of the photovoltaic modules respectively correspond to the pieces of identification information of the plurality of micro-inverters, and may correspond the first code to any one of a plurality of second codes based on the database.

According to an embodiment, the processor 120 may be implemented as a central processing unit (CPU), a graphics processing unit (GPU), an application processor (AP), a neural processing unit (NPU), an image signal processor (ISP), a sensor hub processor, a communication processor (CP), or the like provided in the apparatus 100, but the present disclosure is not limited thereto.

FIG. 2 is a flowchart illustrating a method of automatically mapping the inverters in the photovoltaic modules according to an embodiment. In the following description, parts that overlap with those described with reference to FIG. 1 will be omitted.

A solar power generation system (not shown) according to the present embodiment may refer to a power generation system that converts solar energy into electric energy. The solar power generation system may include a plurality of photovoltaic (PV) modules, and each of the photovoltaic modules may include a micro-inverter that serves to convert the generated energy.

The photovoltaic module is a module that generates power using the photoelectric effect, and the plurality of photovoltaic modules may be connected to each other to form a photovoltaic module array. The photovoltaic module array may have a form in which the plurality of photovoltaic modules are connected to each other in series or in parallel. In addition, the photovoltaic module array may include at least one photovoltaic module string. According to an embodiment, when the plurality of photovoltaic modules are connected to each other in series, the plurality of photovoltaic modules may form one photovoltaic module array through one photovoltaic module string. In addition, according to an embodiment, when the plurality of photovoltaic modules are connected to each other in parallel, the plurality of photovoltaic modules may form one photovoltaic module array through a plurality of photovoltaic module strings.

Meanwhile, the micro-inverter may be connected to the photovoltaic module in a one-to-one manner and may convert the energy generated by the photovoltaic module.

In the present embodiment, the solar power generation system including at least one photovoltaic module array will be described by way of example.

The solar power generation system may include a plurality of photovoltaic module arrays, and each of the photovoltaic module arrays may include at least one photovoltaic module string including the plurality of photovoltaic modules. Thus, each of the plurality of photovoltaic modules needs to be managed individually.

Accordingly, in the process of installing the photovoltaic modules to install the solar power generation system or replacing the photovoltaic module, a user may match identification information of the photovoltaic module or identification information of the micro-inverter with position information about a position in which the photovoltaic module or the micro-inverter is installed.

Referring to FIG. 2, in operation 201, the processor 120 may receive a list of pieces of identification information for micro-inverters respectively corresponding to a plurality of installed photovoltaic modules.

The solar power generation system may include a plurality of photovoltaic modules, and the micro-inverters may correspond to the photovoltaic modules in a one-to-one manner.

The list of pieces of identification information may refer to a list including pieces of identification information of the micro-inverters installed in the solar power generation system. The Identification information of the micro-inverter may include a serial number that is set when the micro-inverter is manufactured or shipped. In addition, according to an embodiment, the identification information of the micro-inverter may include an address, a product number, or the like that is assigned to the micro-inverter. The identification information of the micro-inverter may be configured by combining letters, numbers, or symbols. In addition, the identification information of the micro-inverter may be set to represent a regularity depending on the installation positions or arrangement structure of the micro-inverters.

Meanwhile, the processor 120 may receive information about a position in which the solar power generation system is to be installed. For example, the processor 120 may receive information about the shape and size of a roof or rooftop of a building in which the solar power generation system is to be installed, or a blueprint of the building, and may calculate a position in which the photovoltaic modules can be installed based on the received information. In this case, the processor 120 may calculate an optimal position in which the solar power generation system generates the most power based on the information and performance of the photovoltaic module and the micro-inverter.

In operation 202, the processor 120 may receive a first image including a plurality of first codes from a user.

The first image, which includes the first codes, may include a plurality of zones, and each of the zones may be used to represent position and identification information of the micro-inverter.

The first code may be in the form of a one-dimensional (1D) barcode or a two-dimensional (2D) barcode. The 1D barcode may include a code that consists of lines and represents information horizontally. The 2D barcode may include a code that is square or rectangular in shape and represents information horizontally and vertically.

According to an embodiment, the first code may include a quick response code (QR code) among types of the 2D barcode, and the QR code may be used to represent the identification information of the micro-inverter. Thus, the first code may include identification information such as a serial number, a product number, or the like of the micro-inverter, and the processor 120 may obtain the identification information of the micro-inverter corresponding to the first code by recognizing or scanning the first code.

Meanwhile, the first code is not limited to a 2D barcode, and may also be a 1D barcode in the form of a barcode or another form of identifier symbol, but hereinafter, for convenience of description, the first code will be described as being in the form of a QR code.

According to an embodiment, the processor 120 may obtain the first image, which includes the first codes, by capturing or scanning the image, and according to another embodiment, the processor 120 may obtain the first image directly from user input.

The user (or installer) may obtain the first code including the identification information of the micro-inverter while installing a solar power generation system, and attach or place the first code on a photograph to correspond to the position information about the position in which the micro-inverter is installed. Specifically, when installing the micro-inverter, the user (or installer) may remove the first code attached to the micro-inverter and attach the removed first code to a zone within the paper template, which corresponds to the position of the micro-inverter. Accordingly, the first image, which includes he first codes, may be in the form of a photograph of the paper template to which the first code is attached. The first image according to the present embodiment is not a physical photograph in the strict sense, but may include a form that may include position and identification information.

The first image, which includes the first codes, may include a plurality of zones divided in the form of a table. For example, rows in the table may be represented by numeric indices such as 1, 2, 3, ..., while columns in the table may be represented by alphabetical indices such as A, B, C, .... Thus, in this case, any cell in the table may be represented using a row index and a column index, and a zone in a first row and a first column in the table may be denoted as A1.

In operation 203, the processor 120 may recognize the first codes and obtain pieces of position and identification information of the micro-inverters corresponding to the first codes.

The processor 120 may identify pieces of coordinate information of the zones, to which the first codes are attached, from the received first image, and may obtain the pieces of position information of the micro-inverters using the coordinate information. For example, when the processor 120 obtains the first image, in which the first code is attached to the zone in the first row and the first column, the coordinate information of the zone to which the first code is attached may be A1, and the processor 120 may correspond "A1," which is the coordinate information of the zone, to the position information of the first code.

According to an embodiment, when the first code is attached to a plurality of zones, or is recognized as being attached to the plurality of zones due to a user's mistake or misrecognition of the processor 120, the coordinate information of the zone to which the first code is attached may be recognized as a plurality of pieces of coordinate information. At this point, the processor 120 may calculate and compare an area of the first code included in each zone, and may correspond the coordinate information of the zone including the largest area of the first code to the position information of the first code.

When a zone is recognized as not having the first code attached thereto, the processor 120 may recognize that the micro-inverter is not installed in the corresponding zone.

In operation 204, the processor 120 may generate a first layout diagram of micro-inverters based on the obtained position information and the identification information.

At this point, the processor 120 may receive the first image, which includes the first codes, through an application (APP), generate the first layout diagram of micro-inverters using the application, and send the first layout diagram of micro-inverters to a user terminal.

The first image, which includes the first codes, may include a compass rose or a cardinal identifier that represents cardinal direction information, and the processor 120 may obtain the cardinal direction information based on the compass rose or the cardinal identifier. For example, when the first image is an image in the form in which a compass rose with four cardinal directions is included in the upper left corner of the paper template, the processor 120 may modify an angle of the first image, which includes the first codes and is in the form of a photograph of the paper template, based on the four cardinal directions, and the position information of the micro-inverter may be changed based on the modified angle.

The processor 120 may generate the first layout diagram of micro-inverters based on the position information of the micro-inverter obtained in operation 203 or the position information changed by the cardinal direction information obtained in operation 204. According to an embodiment, the processor 120 may place the first code in the first layout diagram to correspond to the position information, and in addition to the first code, the processor 120 may place the identification information of the micro-inverter or real-time power generation information of the photovoltaic module corresponding to the micro-inverter in the first layout diagram. The processor 120 may receive the power generation information through a controller that may be attached to or connected to the photovoltaic module to control or monitor photovoltaic panels. Here, the power generation information may include voltage, current, power generation, temperature, defect, and the like of the photovoltaic module, and the controller may include a communication module capable of transmitting the monitored information to an external device.

According to an embodiment, when the processor 120 generates the first layout diagram by placing the first code, a user may check a layout status of the micro-inverters through the first layout diagram in the application on the user terminal, and by touching the first code on the first layout diagram, the user may check detailed information about the status or power generation information of each of the micro-inverter and the photovoltaic module corresponding to the first code.

According to another embodiment, when the processor 120 generates the first layout diagram by placing the real-time power generation information, the user may check the layout status of the micro-inverter through the first layout diagram in the application on the user terminal, and may check at a glance the status or power generation information of the photovoltaic module corresponding to the micro-inverter in a schematically represented form.

The user may change the position of the first code in the first layout diagram using drag and drop operations, and the processor 120 may generate the first layout diagram reflecting the position information of the micro-inverter changed by a user's drag and drop input.

In operation 205, the processor 120 may compare the number of the pieces of identification information of the micro-inverters in the list of pieces of identification information with the number of the pieces of identification information corresponding to the plurality of recognized first codes, and when there is a mismatch therebetween, the processor 120 may transmit an alarm and recommend position information, on the first layout diagram of micro-inverters, corresponding to unrecognized first codes.

Specifically, the processor 120 may compare the number of the pieces of identification information of the micro-inverters in the list of pieces of identification information of micro-inverters, which are received in operation 201, with the number of the pieces of identification information of the first codes recognized in operation 203. Cases in which the numbers do not match each other as a result of comparison may include a case in which the first code is not recognized by the processor 120 or a case in which the first code is not attached due to a user's (or installer's) mistake. In this case, the processor 120 may send an alarm to the user about the unrecognized or unattached first code, and may recommend to the user position information of the micro-inverter corresponding to the unrecognized or unattached first code.

The processor 120 may calculate the position information, to which the first code should correspond, based on the optimal position calculated in operation 201 or a position previously input by the user. For example, when there is first position information that should correspond to first codes, but no corresponding first code exists, the processor 120 may recommend the first position information as the position information of the micro-inverter corresponding to the unrecognized or unattached first code.

When there is only one unrecognized or unattached first code, the processor 120 omits the process of sending an alarm and recommending position information for the unrecognized or unattached first code, and then inputs the first position information as the position information of the micro-inverter corresponding to the unrecognized or unattached first code. In addition, the processor 120 may output the first layout diagram, which is generated based on the input first position information, on the user terminal, and may indicate that the first position information has been input for the unrecognized or unattached first code by applying indicators such as different colors, blinking, highlighting, or the like on the first layout diagram.

When there are two or more unrecognized or unattached first codes, there may be a plurality of pieces of first position information that should correspond to first codes, but no corresponding first code exists, the processor 120 may recommend a plurality of pieces of first position information to the user for the position information of the micro-inverters corresponding to the unrecognized or unattached first codes, and input the first position information selected by the user as the position information of the micro-inverters. When one first position information remains unselected by the user, the processor 120 may generate the first layout diagram by inputting the remaining first position information to the first code without position information, even without user selection.

In operation 206, the processor 120 may modify the first layout diagram based on the recommended position information.

In an optional embodiment, the processor 120 may receive a second image from the user, showing an installed state of a plurality of photovoltaic modules. In the present embodiment, the second image may include metadata conforming to the Exchangeable Image File Format (Exif). The metadata may include information about the date and time the second image was captured, information about the model and manufacturer of a camera used, information about the resolution and size of the second image, global positioning system (GPS) information including the latitude, longitude, and altitude of the position in which the second image was captured, and information about capturing conditions at the time the second image was captured, such as an aperture value, a shutter speed, and international organization for standardization (ISO) sensitivity. In addition, the second image may include coordinates of the center of the photovoltaic module or relative position information based on a specific point, enabling the recognition of the position and orientation of the photovoltaic module. The second image may also include environmental elements surrounding the photovoltaic module, such as nearby buildings, trees, and the ground.

In addition, the processor 120 may calculate installation information related to the plurality of photovoltaic modules from the second image. In the present embodiment, the installation information may include a tilt angle and an azimuth angle for the plurality of photovoltaic modules.

In the present embodiment, when calculating installation information, the processor 120 may receive the second image from the user terminal, along with the tilt and azimuth angles for the plurality of photovoltaic modules included in the second image. An acceleration sensor (not shown) and a gyroscope sensor (not shown) may be provided in the user terminal, and by executing the application, the tilt and azimuth angles for the plurality of photovoltaic modules corresponding to the second image may be calculated. The processor 120 may determine the tilt and azimuth angles for the plurality of photovoltaic modules, which are received from the user terminal, as the installation information.

In an optional embodiment, the processor 120 may calculate the tilt and azimuth angles for the plurality of photovoltaic modules from the second image by applying image analysis techniques to the second image.

The processor 120 may detect the roof and the ground from the second image and calculate the tilt angle as the inclination of the roof with respect to the ground. The processor 120 may use color-based segmentation and boundary detection from image processing and vision techniques to extract the roof and the ground from the second image. The roof and the ground generally have different colors or brightness, and thus, the processor 120 may segment the second image based on color information to separate regions of the roof and the ground. A hue-saturation-value (HSV) color space may be used to select and extract specific ranges of colors. For example, roofs are typically gray or brown in color and thus may be separated by selecting the corresponding color range. Canny edge detection or other boundary detection algorithms may be used to detect boundaries of the roof and the ground. Since the boundaries may have different patterns, this allows the roof and the ground to be separated. The processor 120 may calculate the tilt angle as the inclination of the roof with respect to the ground using the separated roof and ground.

The processor 120 may calculate the azimuth angle based on information included in the metadata of the second image and the tilt angle. The information included in the metadata used to calculate the azimuth angle may include information about the date and time the second image was captured, GPS information including the latitude, longitude, and altitude of the position in which the second image was captured. The processor 120 may calculate the solar hour angle from the information about the date and time the second image was captured, and calculate the latitude of the installation position of the photovoltaic module from the GPS information of the second image. The processor 120 may calculate the azimuth angle of the plurality of photovoltaic modules using Equation 1 below. [Equation 1] $azimuth angle = arctan \left(\frac{cosφ ⋅ sinθ ⋅ cosβ - sinφ ⋅ cosθ}{cosβ ⋅ cosθ}\right)$ azimuth angle In Equation 1, φ may represent the latitude of the installation position of the photovoltaic module, θ may represent the solar hour angle, and β may represent the above-described tilt angle.

The processor 120 may determine the calculated tilt and azimuth angles as the installation information related to the plurality of photovoltaic modules.

In an optional embodiment, when calculating installation information, the processor 120 may generate installation information related to the plurality of photovoltaic modules corresponding to the second image using a deep neural network model that is pre-trained to generate the installation information related to the plurality of photovoltaic modules in response to an image showing the installed state of the plurality of photovoltaic modules. Here, the deep neural network model may be a model trained using a supervised learning method, with the image showing the installed state of the plurality of photovoltaic modules as input, and the tilt and azimuth angles of the photovoltaic modules as labels.

The processor 120 may use the labeled training data to train an initially set deep neural network model using a supervised learning method. Here, the initially set deep neural network model is an initial model designed to be configured as a model capable of generating the installation information related to the plurality of photovoltaic modules in response to the image showing the installed state of the plurality of photovoltaic modules, and parameter values may be set to arbitrary initial values. The initial model may be trained using the above-described training data, optimizing parameter values thereof, and completed into a generative model that can accurately generate installation information related to the plurality of photovoltaic modules in response to the image showing the installed state of the plurality of photovoltaic modules.

In an optional embodiment, the processor 120 may load a solar power installation drawing (CAD drawing) that is required to be submitted during the installation of photovoltaic modules, and calculate the tilt and azimuth angles from the solar power installation drawing.

In general, when installing photovoltaic modules, the solar power installation drawing may be submitted to government agencies to ensure compliance with local building regulations and solar power regulations." The solar power installation drawing may include installation positions and orientations of photovoltaic modules, electrical connections and wiring, structural elements of supports used during installation, and relative position and connection information of photovoltaic modules and micro-inverters. Here, the installation position and orientation of the photovoltaic module may include installation orientation and tilt information of the photovoltaic module. The processor 120 may extract the installation orientation and tilt information of the photovoltaic module from the solar power installation drawing, and determine the extracted installation orientation and tilt information as an azimuth angle and a tilt angle, respectively.

In an optional embodiment, upon completing the calculation of the tilt and azimuth angles of the photovoltaic module, the processor 120 may generate a second layout diagram by modifying the first layout diagram of micro-inverters based on the installation information including the tilt and azimuth angles of the photovoltaic module, and output the second layout diagram to the user terminal. Here, modifying the first layout diagram may include rotating the first layout diagram based on the tilt and azimuth angles. Accordingly, the processor 120 may generate a modification result of the first layout diagram by rotating the first layout diagram based on the tilt and azimuth angles included in the installation information, and determine the modification result of the first layout diagram as the second layout diagram.

In the present embodiment, the processor 120 may record the installation information including the tilt and azimuth angles of the photovoltaic module in the second layout diagram of micro-inverters, and output the second layout diagram of micro-inverters, in which the installation information including the tilt and azimuth angles of the photovoltaic module is recorded, to the user terminal. In another embodiment, the processor 120 may record the installation information, including the tilt and azimuth angles of the photovoltaic module, outside the second layout diagram, and output the second layout diagram and the installation information, including the tilt and azimuth angles of the photovoltaic module, to the user terminal.

In an optional embodiment, the processor 120 may record the tilt and azimuth angles of the photovoltaic module in the first layout diagram of micro-inverters, and outputs the first layout diagram of micro-inverters, in which the tilt and azimuth angles of the photovoltaic module are recorded, to the user terminal. In another embodiment, the processor 120 may record the installation information, including the tilt and azimuth angles of the photovoltaic module, outside the first layout diagram, and output the first layout diagram and the installation information, including the tilt and azimuth angles of the photovoltaic module, to the user terminal.

In the present embodiment, the first code may be replaced with the second code, and the processor 120 may receive the first image from the user, in which some or all of the first codes are replaced with the second codes.

The second code may be in the form of a 1D barcode or a 2D barcode The 1D barcode may refer to a code that consists of lines and represents information horizontally. The 2D barcode may include a code that is square or rectangular in shape and represents information horizontally and vertically.

According to an embodiment, the second code may include a barcode in the form of a 1D barcode, which may be used to represent identification information of the photovoltaic module. Thus, the second code may include identification information such as a serial number, a product number, or the like of the photovoltaic module, and the processor 120 may obtain identification information of the photovoltaic module corresponding to the second code by recognizing or scanning the second code.

Meanwhile, the second code is not limited to the 1D barcode, and may be the 2D barcode in the form of QR code or another form of identifier symbol, but hereinafter, for convenience of description, the second code will be described as being in the form of a bar code.

According to an embodiment, the processor 120 may obtain the first image, which includes the second codes, by capturing or scanning the image, and according to another embodiment, the processor 120 may obtain the first image directly from user input.

Since the micro-inverter may correspond to the photovoltaic module in a one-to-one manner, the first code including the identification information of the micro-inverter may be replaced with the second code including the identification information of the photovoltaic module. In addition, the processor 120 may obtain the identification information of the photovoltaic modules respectively corresponding to the identification information of the micro-inverters from a preset database. According to another embodiment, the processor 120 may build a database to correspond the identification information of the micro-inverters to the identification information of the photovoltaic modules in a one-to-one manner. Thus, when the identification information of the micro-inverters is lost or unrecognizable, the user may attach the second code, which corresponds to the first code, on the paper template instead of the first code, and the processor 120 may obtain the first code corresponding to the second code using the built database. That is, the processor 120 may obtain the identification information of the micro-inverter corresponding to the identification information of the photovoltaic module using the database.

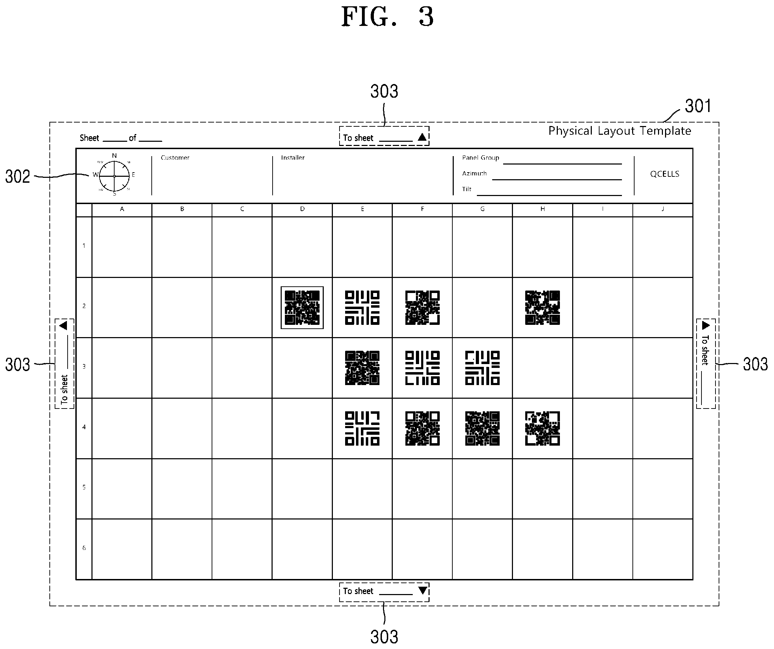

FIG. 3 is an exemplary diagram of the first image including a plurality of first codes according to an embodiment. In the following description, parts that are redundant with the description of FIGS. 1 and 2 will be omitted.

Referring to FIG. 3, a first image 301, which includes a plurality of first codes, is in the form of a photograph of a paper template, and when installing a solar power generation system, a user (or installer) may obtain first codes 304 containing pieces of identification information of micro-inverters, and attach or place the first code 304 on the paper template so as to correspond to position information about a position in which the micro-inverter is installed.

Specifically, when installing the micro-inverter, the user (or installer) may remove the first code 304 attached to the micro-inverter and attach the removed first code 304 to a zone within the paper template, which corresponds to the position of the micro-inverter. Accordingly, the first image 301 including the first codes may refer to an image in the form of a photograph of a paper template to which the first codes 304 are attached. The image according to the present embodiment is not a physical photograph in the strict sense, but may refer to a form that may include position and identification information.

In addition, the first image 301 including the first codes 304 may include a compass rose 302 or a cardinal identifier 303 representing cardinal direction information, and the processor 120 may obtain the cardinal direction information based on the compass rose 302 or the cardinal identifier 303. For example, when the compass rose 302 is included in the first image 301 including the first codes 304, the processor 120 may modify an angle of the first image 301 inducing the first codes based on the compass rose 302. When the cardinal identifier 303 is included in the first image 301 including the first codes, the cardinal identifier 303 may be a combination of letters, numbers, symbols, marks, and the like, and the processor 120 may recognize the position or orientation of the cardinal identifier 303 through character recognition. The processor 120 may modify the angle of the first image 301 including the first codes, so that the position or orientation of the first code 304 matches a position or orientation preset by the user.

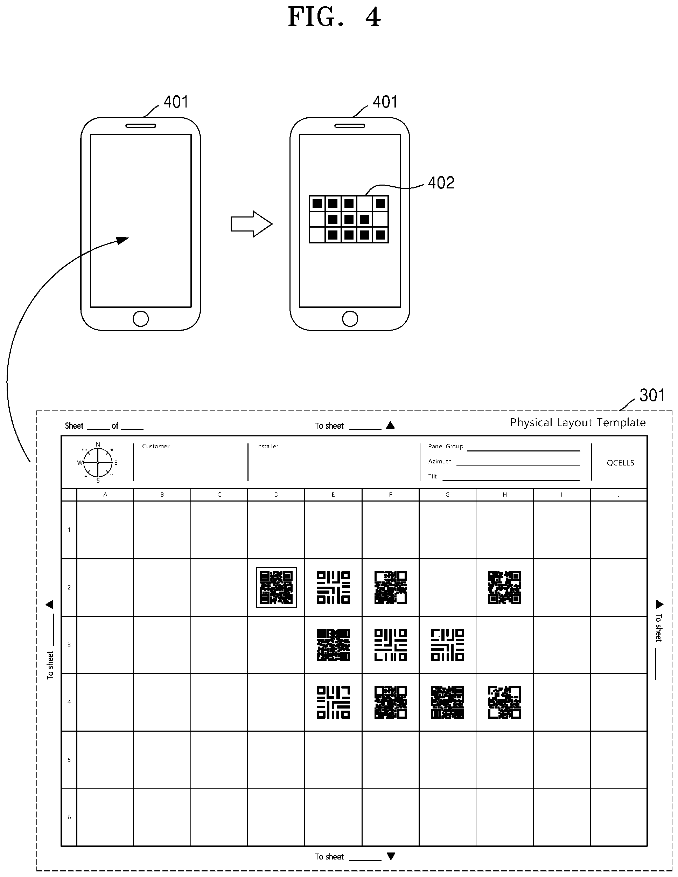

FIG. 4 is an exemplary diagram illustrating a process of recognizing the first image and outputting a first layout diagram, according to an embodiment. In the following description, parts that are redundant with the description of FIGS. 1 to 3 will be omitted.

Referring to FIG. 4, the processor 120 may receive, using a user terminal 401, the first image 301 including the first codes from the user. Specifically, the processor 120 may receive the first image 301 including the first codes from the user through an application in the user terminal 401. According to an embodiment, the application in the user terminal 401 may be displayed on a display interface of the user terminal 401, and icons corresponding to functions for receiving or capturing images may be displayed on a user interface of the application displayed on the user terminal 401.

For example, the user may touch a photo album icon corresponding to a function for receiving images to input the first image 301, which includes the plurality of first codes, into the user terminal 401, and the user terminal 401 may display images stored therein. When the user selects the first image 301 including the first codes among the displayed images, the processor 120 may obtain the first image 301, which includes the plurality of first codes, selected by the user. In another embodiment, the user may touch, using the user terminal 401, a camera icon corresponding to a function for capturing images to capture the first image 301 including the plurality of first codes, and the user terminal 401 may capture an image with an internal camera to obtain the first image 301 including the plurality of first codes.

When the processor 120 obtains the first image 301 including the plurality of first codes, the processor 120 may recognize the first codes and obtain position and identification information of the micro-inverters respectively corresponding to the first codes. The processor 120 may generate a first layout diagram 402 of micro-inverters based on the obtained position and identification information, and output the first layout diagram 402 of micro-inverters to the user interface of the application in the user terminal 401. Meanwhile, when the first code is not present in any column or row of the first layout diagram 402, the processor 120 may generate and output the first layout diagram 402 in a form in which the corresponding column or row is omitted.

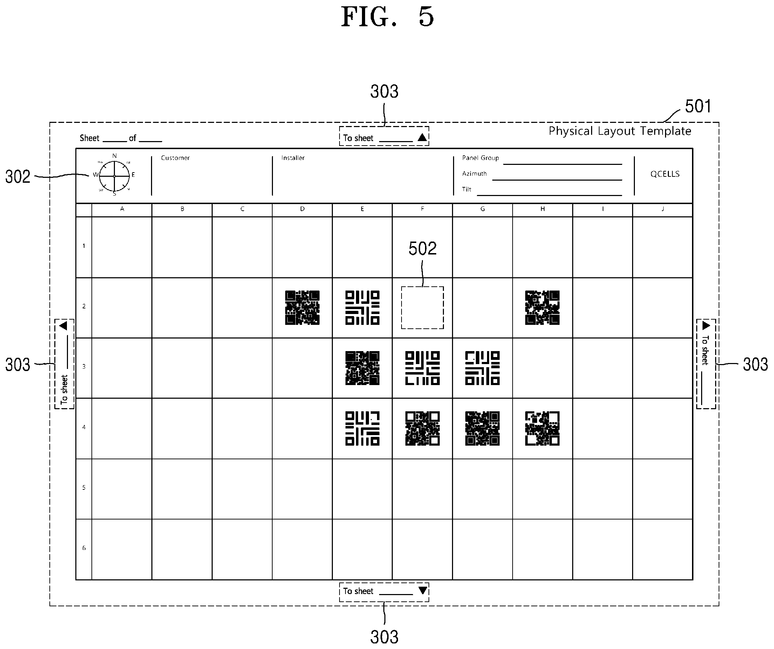

FIG. 5 is an exemplary diagram of a first image with an unattached first code, according to an embodiment. In the following description, parts that are redundant with the description of FIGS. 1 to 4 will be omitted.

Referring to FIG. 5, the processor 120 may receive, using the user terminal 401, a first image 501, which includes a plurality of first codes but has an unattached first code 502, from the user. The processor 120 may compare the number of the pieces of identification information of the micro-inverters in the list of pieces of identification information of the micro-inverters, which is received from the user, with the number of pieces of identification information corresponding to the first codes, which is obtained by recognizing the first image 501 including the plurality of first codes. Cases in which the numbers do not match each other may include a case in which the first code is not recognized by the processor 120 or a case in which the first code is not attached due to a user's (installer's) mistake, but for convenience of description, the following discussion will be made assuming that the first code is not attached by the user.

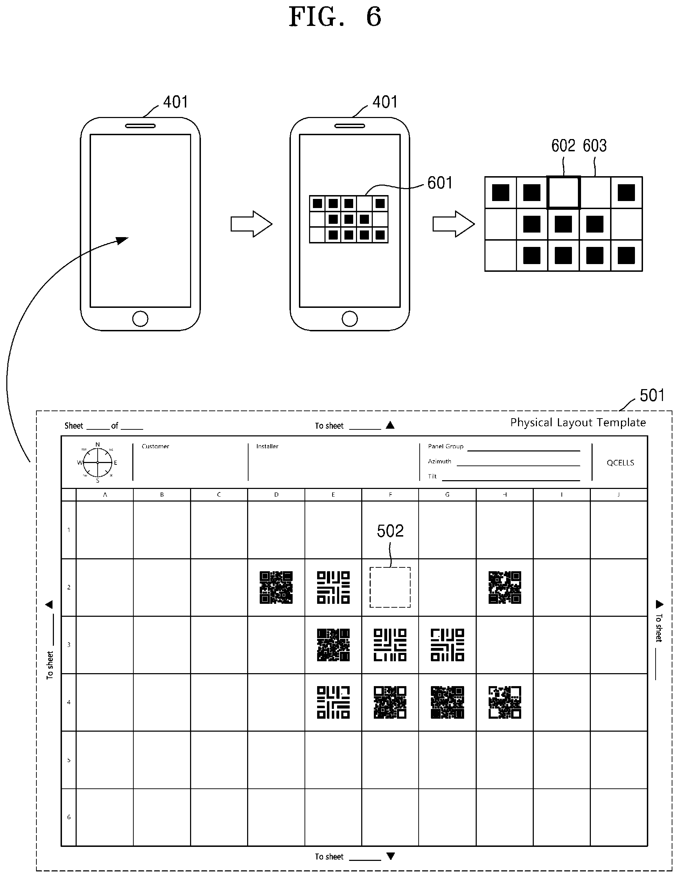

FIG. 6 is an exemplary diagram illustrating a process of recognizing the first image and outputting a first layout diagram, according to another embodiment. In the following description, parts that are redundant with the description of FIGS. 1 to 5 will be omitted.

Referring to FIG. 6, the processor 120 may receive, using the user terminal 401, the first image 501 with the unattached first code 502 from the user (installer). When the processor 120 obtains the first image 501 including the plurality of first codes, the processor 120 may recognize the first codes and obtain position and identification information of the micro-inverters respectively corresponding to the first codes. The processor 120 may generate a first layout diagram 601 of micro-inverters based on the obtained position and identification information, and output the first layout diagram 601 of micro-inverters to the user interface of the application in the user terminal 401.

Meanwhile, when the first code is not present in any column or row of the first layout diagram 601, the processor 120 may generate and output the first layout diagram 601 in a form in which the corresponding column or row is omitted.

Meanwhile, the processor 120 may compare the number of the pieces of identification information of micro-inverters in the list of pieces of identification information of the micro-inverters, which is received from the user, with the number of pieces of identification information corresponding to the first codes, which is obtained by recognizing the first image 501 including the plurality of first codes, and when the numbers do not match each other, the processor 120 may send an alarm to the user about the unattached first code 502 and may recommend to the user position information of the micro-inverter corresponding to the unrecognized first code 502.

According to an embodiment, the processor 120 may receive information about a position in which a solar power generation system is to be installed and calculate an optimal position for the solar power generation system to generate the most power, based on the information and performance of the photovoltaic modules and the micro-inverters. Alternatively, the processor 120 may receive pieces of position information about positions, in which the micro-inverters are to be installed, from the user.

For example, when the processor 120 receives information from the user that micro-inverters will be installed at positions D2, E2, E3, E4, F2, F3, F4, G3, G4, H2, and H4, but recognizes that first codes are present only at positions D2, E2, E3, E4, F3, F4, G3, G4, H2, and H4, excluding the position of F2, as a result of recognizing the first image 501 including the plurality of first codes, the processor 120 may determine that the unattached first code 502 is present at the position of F2. At this point, the processor 120 may recommend a first position 602 for the position of the unattached first code 502 by applying indicators such as a different color, blinking, highlighting, or the like to the first position 602, which corresponds to the position of F2, on the first layout diagram.

When there is only one unattached first code 502, the processor 120 may omit the process of sending an alarm and recommending position information for the unattached first code 502 and then input information about the first position 602 into the position information of the micro-inverter corresponding to the unattached first code 502. At this point, the processor 120 may output a first layout diagram 603, which is generated based on the input information about the first position 602, to the user terminal 401, and may express that the unattached first code 502 is placed in the first position 602 by applying indicators such as a different color, blinking, highlighting, or the like on the first layout diagram 603 for the unattached first code 502.

When there are two or more or a plurality of unattached first codes 502, there may be a plurality of pieces of information about the first positions 602 that should correspond to first codes, but no corresponding first code exists, the processor 120 may recommend the plurality of pieces of information about the first positions 602 to the user for the position information of the micro-inverters corresponding to the unattached first codes 502, and input the information about the first positions 602 selected by the user as the position information of the micro-inverter. When one piece of information about the first position 602 remains unselected by the user, the processor 120 may generate the first layout diagram 603 by inputting the remaining information about the first position 602 to the first code 502 without position information, even without user selection.

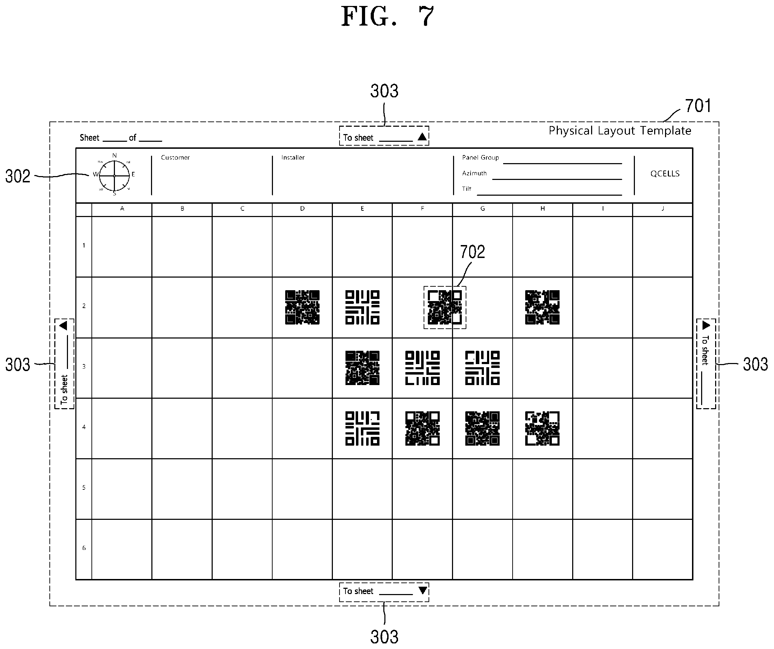

FIG. 7 is an exemplary diagram of a first image including a first code attached to a boundary, according to an embodiment. In the following description, parts that are redundant with the description of FIGS. 1 to 6 will be omitted.

Referring to FIG. 7, the processor 120 may receive, using the user terminal 401, a first image 701, which includes a plurality of first codes but has a first code 702 attached to a plurality of zones, from the user. Cases in which a plurality of pieces of position information correspond to one first code may include a case in which the first code is attached a plurality of zones, or is recognized as being attached to the plurality of zones due to a user's mistake or misrecognition of the processor 120, but for convenience of description, the following discussion will be made assuming that the first code is attached to the plurality of zones by the user.

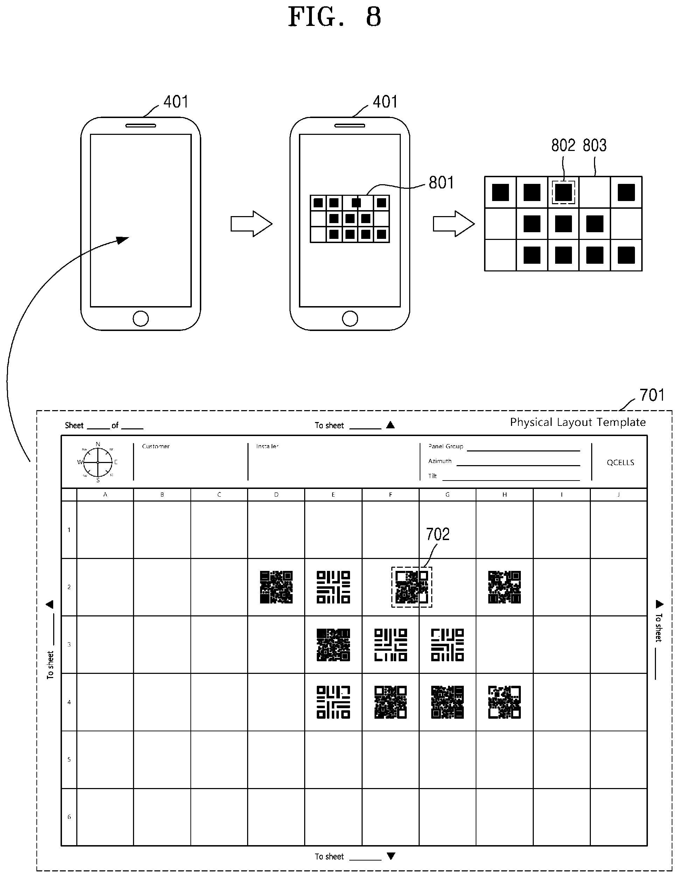

FIG. 8 is an exemplary diagram illustrating a process of recognizing the first image and outputting a first layout diagram, according to another embodiment. In the following description, parts that are redundant with the description of FIGS. 1 to 7 will be omitted.

Referring to FIG. 8, the processor 120 may receive, using the user terminal 401, the first image 701, which has the first code 702 attached to a plurality of zones, from the user. When the processor 120 obtains the first image 701 including the plurality of first codes, the processor 120 may recognize the first codes and obtain position and identification information of the micro-inverters respectively corresponding to the first codes. The processor 120 may generate a first layout diagram 801 of micro-inverters based on the obtained position and identification information, and output the first layout diagram 801 of micro-inverters to the user interface of the application in the user terminal 401. Meanwhile, when the first code is not present in any column or row of the first layout diagram 801, the processor 120 may output the first layout diagram 801 in a form in which the corresponding column or row is omitted.

Meanwhile, when the first code 702 is attached to a plurality of zones, the processor 120 may identify a plurality of pieces of coordinate information of the zones to which the first code 702 is attached. At this point, the processor 120 may calculate and compare an area of the first code 702 included in each zone, and may correspond the coordinate information of the zone including the largest area of the first code 702 to position information of the first code 702. For example, when the first code 702 is attached by the user to span the positions of F2 and G2, the processor 120 may compare an area of the first code 702 included in the zone of F2 with an area of the first code 702 included in the zone of G2. According to an embodiment, when the area of the first code 702 attached to the zone of F2 is greater than the area of the first code 702 attached to the zone of G2, the processor 120 may correspond "F2" to the position information of the first code 702.

The processor 120 may output, to the user terminal 401, a first layout diagram 803, which is generated based on information about a position 802 corresponding to "F2" that is position information of the first code 702.

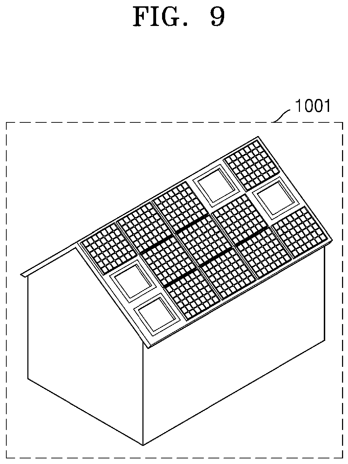

FIG. 9 is an exemplary diagram of a second image showing an installed state of a plurality of photovoltaic modules, according to an embodiment. In the following description, parts that are redundant with the description of FIGS. 1 to 8 will be omitted.

Referring to FIG. 9, the processor 120 may receive a second image 1001 showing an installed state of a plurality of photovoltaic modules from the user. In the present embodiment, the second image may include metadata including information about the date and time the second image was captured, GPS information including the latitude, longitude, altitude of the position in which the second image was captured, and the like. In addition, the second image may include coordinates of the center of the photovoltaic module or relative position information based on a specific point, enabling the recognition of the position and orientation of the photovoltaic module. The second image may also include environmental elements surrounding the photovoltaic module, such as nearby buildings, trees, and the ground.

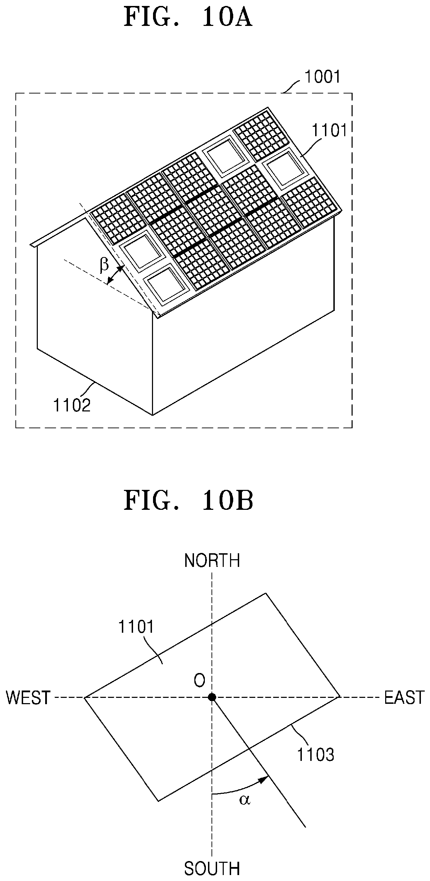

FIGS. 10A and 10B are exemplary diagrams illustrating the calculation of installation information from the second image, according to an embodiment. In the following description, parts that are redundant with the description of FIGS. 1 to 9 will be omitted.

Referring to FIGS. 10A and 10B, the processor 120 may calculate installation information including tilt and azimuth angles for a plurality of photovoltaic modules based on the second image 1001.

In FIG. 10A, an embodiment in which the tilt angle for a plurality of photovoltaic modules is calculated is illustrated. Referring to FIG. 10A, the processor 120 may detect a roof (root surface) 1101 and a ground 1102 from the second image 1001 using color-based segmentation and boundary detection from image processing and vision techniques. Since the roof (roof surface) 1101 and the ground 1102 generally have different colors or brightness, the processor 120 can segment the second image 1001 based on the color information to separate the regions of the roof and the ground. In addition, the processor 120 may detect boundaries of the roof 1101 and the ground 1102 using Canny edge detection or other boundary detection algorithms. Since the boundaries may have different patterns, this allows the roof 1101 and the ground 1102 to be separated. Using the separated roof 1101 and ground 1102, the processor 120 may calculate a tilt angle β as an inclination of the roof 1101 with respect to the ground 1102.

In FIG. 10B, an embodiment in which the azimuth angle for a plurality of photovoltaic modules is calculated is illustrated. Referring to FIG. 10B, the processor 120 may draw an imaginary line passing from a center O of the roof surface 1101 through the center of a southern side 1103 of the roof surface 1101 and calculate the azimuth angle as an angle measured in a clockwise (westward) direction from the due south direction to the imaginary line. When the imaginary line is located in a counterclockwise (eastward) direction from the due south direction, the measured angle may be expressed as a negative value (-)." When the azimuth angle α is a negative value (-), which means that the southern side 1103 of the roof surface 1101 is oriented from south to east, as shown in FIG. 10B. In contrast, when the azimuth angle α is a positive value (+), which may mean that the southern side 1103 of the roof surface 1101 is turned from south to west.

In an optional embodiment, in order to calculate the azimuth angle α, the processor 120 may use the information about the date and time the second image 1001 was captured and the GPS information including the latitude, longitude, altitude of the position in which the second image 1001 was captured, which are included in the metadata of the second image 1001, and the tilt angle β that is calculated with reference to FIG. 10A. The processor 120 may calculate a solar hour angle (θ)from the information about the date and time the second image 1001 was captured, and calculate a latitude φ of the installation position of the photovoltaic module from the GPS information of the second image 1001. The processor 120 may calculate the azimuth angle α of the plurality of photovoltaic modules using Equation 1 described above. In the present embodiment, an orientation refers to the relative direction of an object or position, simply indicating its position, whereas an azimuth angle may include the concept of accurately describing the orientation of an object as an angle relative to a specific axis.

In an embodiment, the processor 120 may receive the second image 1001 from the user terminal 401 along with the tilt and azimuth angles for the plurality of photovoltaic modules included in the second image 1001.

In another embodiment, when calculating installation information, the processor 120 may generate installation information related to the plurality of photovoltaic modules corresponding to the second image using a deep neural network model that is pre-trained to generate the installation information related to the plurality of photovoltaic modules in response to an image showing the installed state of the plurality of photovoltaic modules. Here, the deep neural network model may be a model trained using a supervised learning method, with the image showing the installed state of the plurality of photovoltaic modules as input, and the tilt and azimuth angles of the photovoltaic modules as labels.

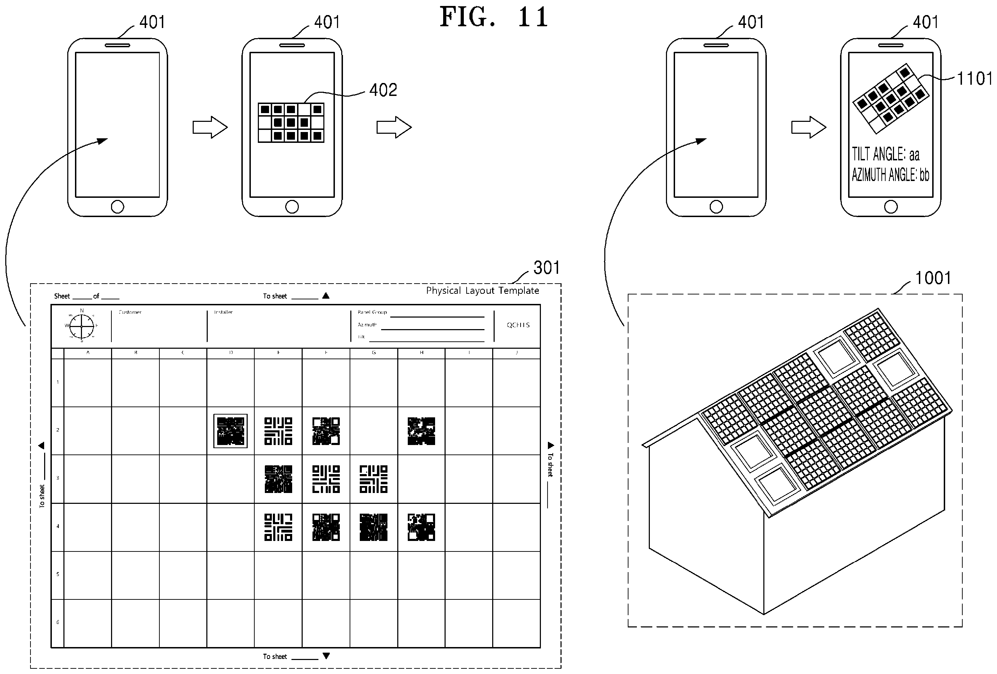

FIG. 11 is an exemplary diagram illustrating a process of outputting a second layout diagram based on the installation information, according to an embodiment. In the following description, parts that are redundant with the description of FIGS. 1 to 10B will be omitted.

Referring to FIG. 11, the processor 120 may receive, using the user terminal 401, the first image 301 including first codes from the user. Specifically, the processor 120 may receive the first image 301 including the first codes from the user through an application in the user terminal 401. According to an embodiment, the application in the user terminal 401 may be displayed on a display interface of the user terminal 401, and icons corresponding to functions for receiving or capturing images may be displayed on a user interface of the application displayed on the user terminal 401. For example, the user may touch a photo album icon corresponding to a function for receiving images to input the first image 301, which includes the plurality of first codes, into the user terminal 401, and the user terminal 401 may display images stored therein. When the user selects the first image 301 including the first codes among the displayed images, the processor 120 may obtain the first image 301, which includes the plurality of first codes, selected by the user. In another embodiment, the user may touch, using the user terminal 401, a camera icon corresponding to a function for capturing images to capture the first image 301 including the plurality of first codes, and the user terminal 401 may capture an image with an internal camera to obtain the first image 301 including the plurality of first codes.

When the processor 120 obtains the first image 301 including the plurality of first codes, the processor 120 may recognize the first codes and obtain position and identification information of the micro-inverters respectively corresponding to the first codes. The processor 120 may generate the first layout diagram 402 of micro-inverters based on the obtained position and identification information, and output the first layout diagram 402 of micro-inverters to the user interface of the application in the user terminal 401. Meanwhile, when the first code is not present in any column or row of the first layout diagram 402, the processor 120 may generate and output the first layout diagram 402 in a form in which the corresponding column or row is omitted.

Meanwhile, the processor 120 may receive, using the user terminal 401, the second image 1001 showing the installed state of the plurality of photovoltaic modules from the user. The processor 120 may calculate installation information including the tilt and azimuth angles from the second image 1001. The processor 120 may generate a second layout diagram 1101 by modifying the first layout diagram 402 of micro-inverters based on the installation information including the tilt and azimuth angles of the photovoltaic modules, and output the second layout diagram 1101 to the user terminal. In the present embodiment, modifying the first layout diagram 402 may include rotating the first layout diagram based on the tilt and azimuth angles.

The processor 120 may record the installation information, which includes the tilt and azimuth angles of the photovoltaic modules, in the second layout diagram 1101 of micro-inverters and output the second layout diagram 1101 to the user terminal 401. In another embodiment, the processor 120 may record the installation information, including the tilt and azimuth angles of the photovoltaic module, outside the second layout diagram 1101, and output the second layout diagram 1101 and the installation information, including the tilt and azimuth angles of the photovoltaic module, to the user terminal.

In an optional embodiment, the processor 120 may record the tilt and azimuth angles of the photovoltaic module in the first layout diagram 402 of micro-inverters, and output the first layout diagram 402 of micro-inverters, in which the tilt and azimuth angles of the photovoltaic module are recorded, to the user terminal 401. In another embodiment, the processor 120 may record the installation information, including the tilt and azimuth angles of the photovoltaic module, outside the first layout diagram 402, and output the first layout diagram 402 and the installation information, including the tilt and azimuth angles of the photovoltaic module, to the user terminal 401.

The embodiments according to the present disclosure described above may be implemented in the form of a computer program that can be executed through various components on a computer, and such a computer program may be described on a computer-readable medium. Here, the medium may include hardware devices specially configured to store and execute program instructions, including magnetic media such as a hard disk, a floppy disk, and a magnetic tape, optical media such as a compact disc read-only memory (CD-ROM) and a digital versatile disk (DVD), magneto-optical media such as a floptical disk, and solid state drives such as a read-only memory (ROM), a random access memory (RAM), and a flash memory.

Meanwhile, the computer program may be a program specially designed and configured for the present disclosure or a program known and usable to those skilled in the computer software field. Examples of the computer program include machine language codes generated by a compiler as well as high-level language codes that are executable by a computer using an interpreter or the like.

The use of the terms "a" and "an" and "the" and similar referents in the context of describing the present disclosure (especially in the context of the following claims) are to be construed to cover both the singular and the plural. Further, recitation of ranges of values herein are merely intended to serve as a shorthand method of referring individually to each separate value falling within the range, unless otherwise indicated herein, and each separate value is incorporated into the specification as if it were individually recited herein.

When there is no apparent description of the order of operations constituting the method according to the present disclosure or a contrary description thereof, the operations may be performed in an appropriate order. The present disclosure is not limited to the described order of the operations. The use of all examples or exemplary terms (for example, and the like) in the present disclosure are to simply describe the present disclosure in detail, and unless the range of the present disclosure is not limited by the examples or the exemplary terms unless limited by the claims. In addition, it would be apparent to those of ordinary skill in the art that various modifications and changes may be easily made without departing from the scope and spirit of the present disclosure.

Therefore, it should be noted that the spirit of the present disclosure is not limited to the embodiments described above, and not only the claims to be described below, but also all ranges equivalent to or equivalently changed from the claims fall within the scope of the spirit of the present disclosure.

## Claims

1. A method of automatically mapping inverters in photovoltaic modules, the method comprising:
receiving a list of pieces of identification information about micro-inverters respectively corresponding to a plurality of photovoltaic modules that are installed;
receiving a first image including a plurality of first codes from a user;
obtaining position information and identification information of the micro-inverter corresponding to the first code by recognizing the first codes;
generating a first layout diagram of the micro-inverters based on the obtained position information and identification information;
comparing the number of the pieces of identification information of the micro-inverters in the list of pieces of identification information with the number of pieces of identification information corresponding to the recognized plurality of first codes, and sending an alarm and recommending position information of a micro-inverter corresponding to an unrecognized first code on the first layout diagram, when the numbers do not match each other; and
modifying the first layout diagram based on the recommended position information.

2. The method of claim 1, further comprising:
receiving a second image showing an installed state of the plurality of photovoltaic modules from the user;
calculating installation information related to the plurality of photovoltaic modules from the second image; and
generating a second layout diagram by modifying the first layout diagram based on the installation information.

3. The method of claim 1, wherein the obtaining of the position information and the identification information of the micro-inverter includes recognizing the first code included in the first image, identifying coordinate information of a zone to which the first code is attached, and obtaining the position information of the micro-inverter using the coordinate information.

4. The method of claim 3, wherein the obtaining of the position information and the identification information of the micro-inverter includes, when the coordinate information of the zone to which the first code is attached is identified as a plurality of pieces of coordinate information, obtaining the position information of the micro-inverter using the coordinate information of the zone having a largest area of the first code.

5. The method of claim 3, wherein the generating of the first layout diagram includes:
obtaining cardinal direction information from the first image;
changing the position information of the micro-inverter based on the cardinal direction information; and
generating the first layout diagram based on the changed position information and the identification information.

6. The method of claim 1, wherein the generating of the first layout diagram includes:
reflecting position information of the micro-inverter changed by a user's drag and drop input; and
generating the first layout diagram based on the reflected position information and the identification information.

7. The method of claim 1, wherein the first code is replaceable with a second code corresponding to the identification information of the photovoltaic module.

8. The method of claim 7, further comprising:
obtaining pieces of identification information of the photovoltaic modules, which respectively correspond to pieces of identification information of a plurality of micro-inverters, from a database; and
corresponding the first code to one of the plurality of second codes, based on the database.

9. An apparatus for automatically mapping inverters in photovoltaic modules, the apparatus comprising:
at least one processor; and
at least one memory;
wherein the at least one processor is configured to:
receive a list of pieces of identification information about micro-inverters respectively corresponding to a plurality of photovoltaic modules that are installed;
receive a first image including a plurality of first codes from a user;
obtain position information and identification information of the micro-inverter corresponding to the first code by recognizing the first codes;
generate a first layout diagram of the micro-inverters based on the obtained position information and identification information;
compare the number of the pieces of identification information of the micro-inverters in the list of pieces of identification information with the number of pieces of identification information corresponding to the recognized plurality of first codes, and send an alarm and recommend position information of a micro-inverter corresponding to an unrecognized first code on the first layout diagram, when the numbers do not match each other; and
modify the first layout diagram based on the recommended position information.

10. The apparatus of claim 9, wherein the at least one processor is further configured to recognize the first code included in the first image, identify coordinate information of a zone to which the first code is attached, and obtain the position information of the micro-inverter using the coordinate information.

11. The apparatus of claim 10, wherein the at least one processor is further configured to, when the coordinate information of the zone to which the first code is attached is identified as a plurality of pieces of coordinate information, obtain the position information of the micro-inverter using the coordinate information of the zone having a largest area of the first code.

12. The apparatus of claim 9, wherein the at least one processor is further configured to obtain cardinal direction information from the first image, change the position information of the micro-inverter based on the cardinal direction information, and generate the first layout diagram based on the changed position information and the identification information.

13. The apparatus of claim 9, wherein the at least one processor is further configured to reflect position information of the micro-inverter changed by a user's drag and drop input, and generate the first layout diagram based on the reflected position information and the identification information.

14. The apparatus of claim 9, wherein the first code is replaceable with a second code corresponding to the identification information of the photovoltaic module.

15. The apparatus of claim 14, wherein the at least one processor is further configured to obtain pieces of identification information of the photovoltaic modules, which respectively correspond to pieces of identification information of a plurality of micro-inverters, from a database, and correspond the first code to one of a plurality of second codes based on the database.
